# FASCICULE DE BREVET EUROPEEN

(11) **EP 3 682 485 B1**
(45) Date de publication et mention de la délivrance du brevet: **07.07.2021**
(21) Numéro de dépôt: 18780187.3
(22) Date de dépôt: 12.09.2018
(51) Int. Cl.: H01L 31/0216, H01L 31/0224

(54) **PROCÉDÉ DE FABRICATION D'UNE CELLULE PHOTOVOLTAÏQUE À HOMOJONCTION**
VERFAHREN ZUR HERSTELLUNG EINER PHOTOVOLTAISCHEN ZELLE MIT HOMOÜBERGANG
PROCESS FOR MANUFACTURING A HOMOJUNCTION PHOTOVOLTAIC CELL

(30) Priorité: 15.09.2017 FR 1758559
(43) Date de publication de la demande: 22.07.2020
(73) Titulaire: Commissariat à l'Energie Atomique et aux Energies Alternatives, 75015 Paris (FR)
(72) Inventeur: CABAL, Raphaël, 73000 Chambery (FR)
(74) Mandataire: INNOV-GROUP
(86) Numéro de dépôt international: PCT/FR2018/052230
(87) Numéro de publication internationale: WO 2019/053368

(56) Documents cités:
- WO-A1-2011/035090
- STODOLNY M K ET AL: "n-Type polysilicon passivating contact for industrial bifacial n-type solar cells", SOLAR ENERGY MATERIALS AND SOLAR CELLS, ELSEVIER SCIENCE PUBLISHERS, AMSTERDAM, NL, vol. 158, 7 juillet 2016 (2016-07-07), pages 24-28, XP029757045, ISSN: 0927-0248, DOI: 10.1016/J.SOLMAT.2016.06.034
- R PEIBST ET AL: "IMPLEMENTATION OF N + AND P + POLO JUNCTIONS ON FRONT AND REAR SIDE OF DOUBLE-SIDE CONTACTED INDUSTRIAL SILICON SOLAR CELLS", 32TH EUROPEAN PHOTOVOLTAIC SOLAR ENERGY CONFERENCE, PROCEEDINGS OF THE 32TH INTERNATIONAL CONFERENCE, 21 juin 2016 (2016-06-21), pages 323-327, XP055472241, Sylvensteinstr. 2 81369 Munich, Germany ISBN: 978-3-936338-41-6

## Description

### Domaine technique

L'invention se rapporte au domaine technique des cellules photovoltaïques de silicium à homojonction. Plus précisément, l'invention concerne la fabrication d'une cellule photovoltaïque bifaciale, c'est-à-dire comportant :
- une première surface, destinée à être exposée directement au rayonnement solaire ;
- une seconde surface opposée, pouvant recevoir indirectement le rayonnement solaire, par exemple par rayonnement diffus ou par effet albédo.

L'invention trouve notamment son application dans la fabrication d'une cellule photovoltaïque à homojonction dite « haute température », c'est-à-dire dont les matériaux constitutifs sont compatibles avec l'utilisation de traitements thermiques à des températures supérieures à 300°C.

### Etat de la technique antérieure

Une cellule photovoltaïque connue de l'état de la technique, notamment des documents « Passivated rear contacts for high-effciency n-type Si solar cells providing high interface passivation quality and excellent transport characteristics », F. Feldmann et al., Solar Energy Materials & Solar Cells, 120, 270-274, 2014 (ci-après D1), « n-Type polysilicon passivating contact for industrial bifacial n-type solar cells», M.K. Stodolny et al., Solar Energy Materials & Solar Cells, 158, 24-28, 2016 (ci-après D2), « Implementation of n+ and p+ POLO junctions on front and rear side of double-side contacted industrial silicon solar cells», R. Peibst et al., 32nd European Photovoltaic Solar Energy Conférence and Exhibition, 2016 (ci-après D3), comporte :
- un substrat en silicium cristallin, comprenant :
   une première surface (dite face avant), destinée à être exposée à un rayonnement lumineux ;
   une seconde surface (dite face arrière), opposée à la première surface, et recouverte d'un film d'oxyde (généralement appelé oxyde tunnel) ;
- une couche de polysilicium dopé, formée sur le film d'oxyde.

La structure définie par l'empilement oxyde tunnel / couche de polysilicium forme une structure de contact passivé, et permet d'améliorer les performances de la cellule photovoltaïque, à savoir augmenter la tension de circuit ouvert (V_{oc}) par rapport à une cellule photovoltaïque traditionnelle.

Cependant, comme mentionné dans D2, § 3.3, une telle cellule photovoltaïque de l'état de la technique n'est pas entièrement satisfaisante dans la mesure où son industrialisation nécessite une épaisseur assez importante (supérieure à 60 nm ; D2 mentionne les épaisseurs de 70 nm et 200 nm) de la couche de polysilicium dopé si l'on souhaite s'affranchir d'une couche d'oxyde transparent conducteur, coûteuse, sur la couche de polysilicium dopé (présente dans D1 et D3). Or, pour une telle épaisseur, l'absorption parasite des photons au sein de la couche de polysilicium possède un impact préjudiciable en augmentant le courant de court-circuit (I_{cc}) traversant la cellule photovoltaïque.

### Exposé de l'invention

L'invention vise à remédier en tout ou partie aux inconvénients précités.

Une première solution pourrait consister à :
a₀₁) prévoir un substrat en silicium cristallin, comprenant :
   - une première surface, destinée à être exposée à un rayonnement lumineux ;
   - une seconde surface, opposée à la première surface, et recouverte d'un film d'oxyde tunnel ;
b₀₁) former une couche de polysilicium sur le film d'oxyde tunnel ;
c₀₁) former une première couche antireflet sur une partie de la couche de polysilicium de sorte que la couche de polysilicium présente des zones libres ;
d₀₁) graver entièrement les zones libres de la couche de polysilicium.

Les zones libres de la couche de polysilicium sont destinées à s'étendre entre les contacts électriques de la cellule photovoltaïque. Une telle première solution, radicale, permettrait de supprimer l'absorption parasite des photons au sein de la couche de polysilicium entre les contacts électriques (épaisseur nulle) grâce à l'étape d₀₁). Toutefois, une telle première solution ne bénéficie plus de la présence d'un contact passivé (c'est-à-dire la structure oxyde tunnel / couche de polysilicium) entre les contacts électriques de la cellule photovoltaïque, ce qui ne permet pas d'augmenter significativement la V_{oc}.

Une seconde solution pourrait consister à :
a₀₂) prévoir un substrat en silicium cristallin, comprenant :
   - une première surface, destinée à être exposée à un rayonnement lumineux ;
   - une seconde surface, opposée à la première surface, et recouverte d'un film d'oxyde tunnel ;
b₀₂) former une couche de polysilicium sur le film d'oxyde tunnel ;
c₀₂) former une première couche antireflet sur une partie de la couche de polysilicium de sorte que la couche de polysilicium présente des zones libres ;
d₀₂) graver partiellement les zones libres de la couche de polysilicium.

Les zones libres de la couche de polysilicium sont destinées à s'étendre entre les contacts électriques de la cellule photovoltaïque. Une telle seconde solution permettrait de réduire l'absorption parasite des photons au sein de la couche de polysilicium entre les contacts électriques (épaisseur réduite, non nulle) grâce à l'étape d₀₂). Toutefois, une telle seconde solution n'est pas entièrement satisfaisante dans la mesure où l'étape d₀₂) de gravure, pouvant être exécutée par plasma ou par voie humide, est susceptible :
- de ne pas être parfaitement reproductible,
- d'être inhomogène en raison de cinétiques différentes aux joints de grain du polysilicium,
- de causer des dommages de la structure par les espèces chimiques employées.

A cet effet, l'invention a pour objet un procédé de fabrication d'une cellule photovoltaïque, comportant les étapes :
a) prévoir un substrat en silicium cristallin, comprenant :
   - une première surface ;
   - une seconde surface, opposée à la première surface, et recouverte d'au moins un film d'oxyde tunnel ;
b) former une couche de polysilicium sur le film d'oxyde tunnel ;
c) former une première couche antireflet sur une partie de la couche de polysilicium de sorte que la couche de polysilicium présente des zones libres, la première couche antireflet étant adaptée pour assurer une barrière à l'oxydation thermique de ladite partie de la couche de polysilicium ;
d) oxyder thermiquement les zones libres de la couche de polysilicium de manière à former une seconde couche antireflet sur lesdites zones libres.

Ainsi, un tel procédé de fabrication selon l'invention permet de réduire localement l'épaisseur de la couche de polysilicium par consommation de matière liée à l'oxydation thermique exécutée lors de l'étape d). Il en résulte une réduction de l'absorption parasite des photons. Il est à noter que la première couche antireflet formée lors de l'étape c) permet d'assurer un rôle de barrière locale à l'oxydation thermique de la partie de la couche de polysilicium qu'elle recouvre.

En outre, l'oxydation thermique exécutée lors de l'étape d) permet de former une seconde couche antireflet. Les première et seconde couches antireflet permettent d'améliorer la passivation de la seconde surface du substrat.

Enfin, l'oxydation thermique est une technique possédant de bonnes qualités de reproductibilité, d'homogénéité et d'innocuité par rapport à une gravure telle qu'une gravure chimique.

### Définitions

- Par «cristallin», on entend la forme multicristalline ou la forme monocristalline du silicium, excluant donc le silicium amorphe.
- Par « couche antireflet », on entend une unique couche ou un empilement de sous-couches qui, de par une épaisseur adaptée, permet de réduire les pertes optiques liées aux réflexions du rayonnement lumineux, et par là-même permet d'optimiser l'absorption du rayonnement lumineux par le substrat.
- Par « zones libres », on entend des zones de la couche de polysilicium qui ne sont pas recouvertes, et en particulier qui ne sont pas recouvertes par la première couche antireflet. Les zones libres de la couche de polysilicium sont destinées à s'étendre entre les contacts électriques de la cellule photovoltaïque.
- Par «au moins un film d'oxyde tunnel », on entend un unique film d'oxyde ou un empilement comportant une pluralité de films d'oxyde tunnel, l'unique film d'oxyde ou l'empilement étant suffisamment fin pour permettre la circulation d'un courant électrique en son sein par effet tunnel.

Le procédé de fabrication selon l'invention peut comporter une ou plusieurs des caractéristiques suivantes.

Selon une caractéristique de l'invention, l'étape d) est exécutée à une température strictement inférieure à 850°C, de préférence comprise entre 700°C et 800°C.

Ainsi, un avantage procuré est d'éviter, lorsque la couche de polysilicium est dopée, la diffusion de dopants vers le substrat.

Selon une caractéristique de l'invention, la seconde couche antireflet formée à l'issue de l'étape d) est un oxyde thermique de polysilicium présentant une épaisseur comprise entre 40 nm et 100 nm.

Ainsi, un avantage procuré est de pouvoir assurer à la fois une fonction antireflet et une fonction de passivation de la seconde surface du substrat.

Par « épaisseur », on entend la dimension suivant la normale au substrat.

Selon une caractéristique de l'invention, l'étape d) est exécutée en utilisant de la vapeur d'eau.

Ainsi, un avantage procuré est la formation rapide d'un oxyde thermique, favorable à une industrialisation, par rapport à une oxydation thermique sèche (i.e. en présence de dioxygène).

Selon une caractéristique de l'invention, la couche de polysilicium formée lors de l'étape b) présente une épaisseur initiale, et la couche de polysilicium sur laquelle est formée la seconde couche antireflet présente une épaisseur strictement inférieure à l'épaisseur initiale à l'issue de l'étape d).

Ainsi, cela traduit la consommation de matière liée à l'oxydation thermique exécutée lors de l'étape d).

Selon une caractéristique de l'invention, la couche de polysilicium sur laquelle est formée la seconde couche antireflet présente une épaisseur strictement inférieure à 10 nm à l'issue de l'étape d).

Ainsi, un avantage procuré est la réduction significative de l'absorption parasite des photons au sein de la couche de polysilicium.

Selon une caractéristique de l'invention, l'épaisseur initiale de la couche de polysilicium formée lors de l'étape b) est comprise entre 60 nm et 90 nm.

Ainsi, un avantage procuré par une telle gamme d'épaisseurs est de pouvoir exécuter l'étape b) avec des techniques industrielles, par exemple par dépôt chimique en phase vapeur telle que LPCVD (« *Low Pressure Chemical Vapor Deposition* » en langue anglaise).

Selon une caractéristique de l'invention, la partie de la couche de polysilicium sur laquelle est formée la première couche antireflet conserve l'épaisseur initiale à l'issue de l'étape d).

Selon une caractéristique de l'invention, la couche de polysilicium formée lors de l'étape b) est dopée de type p ou de type n avec une concentration de dopants préférentiellement comprise entre 5.10¹⁷ at.cm⁻³ et 5.10²⁰ at.cm⁻³.

Ainsi, un avantage procuré est de réduire la densité de porteurs de charge minoritaires à l'interface avec le substrat tout en autorisant une conductance électrique élevée des porteurs de charge majoritaires en vue des futurs contacts électriques.

Selon une caractéristique de l'invention, la première couche antireflet formée lors de l'étape c) est réalisée dans au moins un matériau sélectionné dans le groupe comportant l'alumine, un nitrure de silicium, un oxyde de titane.

Selon une caractéristique de l'invention, le film d'oxyde tunnel, recouvrant la seconde surface du substrat prévu lors de l'étape a), présente une épaisseur strictement inférieure à 3 nm.

Ainsi, un avantage procuré est d'autoriser la circulation d'un courant électrique par effet tunnel au sein du film d'oxyde tunnel. Un tel oxyde tunnel permet, en combinaison avec la couche de polysilicium, de former un contact passivé.

Selon une caractéristique de l'invention, le substrat prévu lors de l'étape a) et la couche de polysilicium formée lors de l'étape b) sont dopés du même type de conductivité, le substrat présentant préférentiellement une épaisseur strictement inférieure à 250 µm, plus préférentiellement inférieure à 200 µm.

Ainsi, on autorise la formation de jonctions dites « *high-low»* entre la couche de polysilicium et le substrat, c'est-à-dire des jonctions n+/n ou p+/p, impliquant un unique type de conductivité.

L'invention a également pour objet une cellule photovoltaïque, comportant :
- un substrat en silicium cristallin, comprenant :
   une première surface ;
   une seconde surface, opposée à la première surface, et recouverte d'au moins un film d'oxyde tunnel ;
- une couche de polysilicium, formée sur le film d'oxyde tunnel, et comprenant :
   une première partie présentant une première épaisseur de préférence comprise entre 60 nm et 90 nm ;
   une seconde partie, adjacente à la première partie, et présentant une seconde épaisseur strictement inférieure à la première épaisseur, la seconde épaisseur étant de préférence strictement inférieure à 10 nm ;
- une première couche antireflet, formée sur la première partie de la couche de polysilicium, et réalisée dans un premier matériau adapté pour assurer une barrière à l'oxydation thermique du polysilicium ;
- une seconde couche antireflet, formée sur la seconde partie de la couche de polysilicium, et réalisée dans un second matériau différent du premier matériau, le second matériau étant un oxyde thermique de polysilicium.

Ainsi, une telle cellule photovoltaïque selon l'invention permet de limiter la dégradation du courant de court-circuit (I_{cc}) la traversant, tout en augmentant la tension de circuit ouvert (V_{oc}) par rapport à une cellule photovoltaïque traditionnelle.

### Brève description des dessins

D'autres caractéristiques et avantages apparaîtront dans l'exposé détaillé de différents modes de réalisation de l'invention, l'exposé étant assorti d'exemples et de références aux dessins joints.

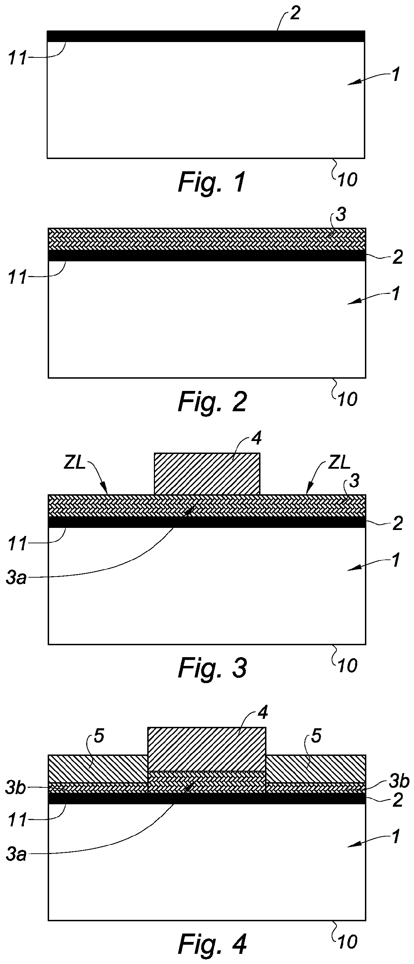

Figures 1 à 4 sont des vues schématiques en coupe illustrant des étapes d'un procédé selon l'invention.
Les figures ne sont pas représentées à l'échelle pour en simplifier leur compréhension.

### Exposé détaillé des modes de réalisation

Les éléments identiques ou assurant la même fonction porteront les mêmes références pour les différents modes de réalisation, par souci de simplification.

Un objet de l'invention est un procédé de fabrication d'une cellule photovoltaïque, comportant les étapes :
a) prévoir un substrat 1 en silicium cristallin, comprenant :
   - une première surface 10 ;
   - une seconde surface 11, opposée à la première surface 10, et recouverte d'au moins un film d'oxyde tunnel 2 ;
b) former une couche de polysilicium 3 sur le film d'oxyde tunnel 2 ;
c) former une première couche antireflet 4 sur une partie 3a de la couche de polysilicium 3 de sorte que la couche de polysilicium 3 présente des zones libres ZL, la première couche antireflet 4 étant adaptée pour assurer une barrière à l'oxydation thermique de ladite partie 3a de la couche de polysilicium 3 ;
d) oxyder thermiquement les zones libres ZL de la couche de polysilicium 3 de manière à former une seconde couche antireflet 5 sur lesdites zones libres ZL.

L'étape a) est illustrée à la figure 1. L'étape b) est illustrée à la figure 2. L'étape c) est illustrée à la figure 3. Enfin, l'étape d) est illustrée à la figure 4.

### Substrat

Le substrat 1 prévu lors de l'étape a) est avantageusement dopé de type n ou de type p. Le substrat 1 prévu lors de l'étape a) et la couche de polysilicium 3 formée lors de l'étape b) sont avantageusement dopés du même type de conductivité. Pour un substrat 1 dopé de type n, le substrat 1 présente préférentiellement une résistivité comprise entre 1 Ω.cm et 7 Ω.cm. Pour un substrat de type p, le substrat 1 présente préférentiellement une résistivité comprise entre 0,5 Ω.cm et 5 Ω.cm.

Le substrat 1 présente préférentiellement une épaisseur strictement inférieure à 250 µm, plus préférentiellement inférieure à 200 µm.

Le silicium dans lequel est réalisé le substrat 1 peut être monocristallin ou polycristallin.

Selon un mode de réalisation, la première surface 10 du substrat 1 est avantageusement destinée à être exposée directement à un rayonnement solaire. La première surface 10 du substrat 1 correspond alors à la face avant de la cellule photovoltaïque tandis que la seconde surface 11 du substrat 1 correspond à la face arrière de la cellule photovoltaïque. La seconde surface 11 du substrat 1 est alors destinée à être exposée indirectement au rayonnement solaire, par rayonnement diffus ou par effet albédo. La couche de polysilicium 3 est donc formée lors de l'étape b) en face arrière de la cellule photovoltaïque.

Selon une alternative, la seconde surface 11 du substrat 1 est destinée à être exposée directement à un rayonnement solaire. La seconde surface 11 du substrat 1 correspond alors à la face avant de la cellule photovoltaïque tandis que la première surface 10 du substrat 1 correspond à la face arrière de la cellule photovoltaïque. La première surface 10 du substrat 1 est alors destinée à être exposée indirectement au rayonnement solaire, par rayonnement diffus ou par effet albédo. La couche de polysilicium 3 est donc formée lors de l'étape b) en face avant de la cellule photovoltaïque.

### Film d'oxyde

En guise de rappel, par « au moins un film d'oxyde tunnel », on entend un unique film d'oxyde 2 ou un empilement 2 (appelé empilement tunnel) comportant une pluralité de films d'oxyde tunnel, l'unique film d'oxyde 2 ou l'empilement 2 étant suffisamment fin pour permettre la circulation d'un courant électrique en son sein.

Le film d'oxyde tunnel 2 ou l'empilement tunnel 2, recouvrant la seconde surface 11 du substrat 1 prévu lors de l'étape a), présente avantageusement une épaisseur strictement inférieure à 3 nm.

Le film d'oxyde tunnel 2 est avantageusement réalisé dans un oxyde de silicium SiOₓ, x≤2. Le film d'oxyde tunnel 2 est préférentiellement formé à la seconde surface 11 du substrat 1 par oxydation thermique. Une oxydation chimique à l'ozone (O₃) est également envisageable.

### Couche de polysilicium

La couche de polysilicium 3 formée lors de l'étape b) présente avantageusement une épaisseur initiale comprise entre 60 nm et 90 nm. La partie 3a de la couche de polysilicium 3 sur laquelle est formée la première couche antireflet 4 conserve l'épaisseur initiale à l'issue de l'étape d) car la première couche antireflet 4 assure une barrière locale à l'oxydation thermique. La couche de polysilicium 3 formée lors de l'étape b) est avantageusement dopée de type p ou de type n avec une concentration de dopants préférentiellement comprise entre 5.10¹⁷ at.cm⁻³ et 5.10²⁰ at.cm⁻³.

Lorsque la couche de polysilicium 3 est formée lors de l'étape b) en face avant de la cellule photovoltaïque, le substrat 1 prévu lors de l'étape a) et la couche de polysilicium 3 formée lors de l'étape b) sont dopés du même type de conductivité.

Lorsque la couche de polysilicium 3 est formée lors de l'étape b) en face arrière de la cellule photovoltaïque, le substrat 1 prévu lors de l'étape a) et la couche de polysilicium 3 formée lors de l'étape b) peuvent être :
- dopés du même type de conductivité, ou
- dopés avec des types de conductivité opposés.

A l'issue de l'étape d), la couche de polysilicium 3b sur laquelle est formée la seconde couche antireflet 5 présente une épaisseur non nulle, strictement inférieure à l'épaisseur initiale, et avantageusement strictement inférieure à 10 nm.

La couche de polysilicium 3 est avantageusement formée lors de l'étape b) par un dépôt d'une couche de silicium amorphe (e.g. par LPCVD «*Low Pressure Chemical Vapor Deposition »* ou par PECVD «*Plasma-Enhanced Chemical Vapor Deposition* ») suivi d'un recuit permettant de cristalliser la couche de silicium amorphe.

### Première couche antireflet

En guise de rappel, par « première couche antireflet », on entend une unique couche ou un empilement de sous-couches qui, de par une épaisseur adaptée, permet de réduire les pertes optiques liées aux réflexions du rayonnement solaire, et par là-même permet d'optimiser l'absorption du rayonnement solaire par le substrat 1. L'unique couche formant la première couche antireflet 4 est réalisée dans un matériau choisi de manière à former une barrière à l'oxydation thermique du polysilicium sous-jacent. De même, l'empilement de sous-couches, formant la première couche antireflet 4, est réalisé dans des matériaux choisis de manière à former une barrière à l'oxydation thermique du polysilicium sous-jacent. Ainsi, le polysilicium disposé sous la première couche antireflet 4 est protégé par la première couche antireflet 4 et ne sera pas oxydé thermiquement pendant l'étape d) destinée à former la seconde couche antireflet 5.

La première couche antireflet 4 formée lors de l'étape c) est avantageusement réalisée dans au moins un matériau sélectionné dans le groupe comportant l'alumine, un nitrure de silicium, un oxyde de titane. Le nitrure de silicium peut comporter de l'oxygène et/ou du carbone. Ainsi, la première couche antireflet 4 peut être une unique couche réalisée à base de SiNₓO_{y}C_{z}, avec x>y et x>z, et de préférence avec y#0. Une telle unique couche présente avantageusement une épaisseur comprise entre 60 nm et 80 nm. Selon une alternative, la première couche antireflet 4 est un empilement comportant une sous-couche réalisée à base de SiNₓO_{y}C_{z}, avec x>y et x>z, et de préférence avec y#0.

A titre d'exemple non limitatif, la première couche antireflet 4 peut être formée par un dépôt chimique en phase vapeur assistée par plasma PECVD («*Plasma-Enhanced Chemical Vapor Deposition* » en langue anglaise).

La première couche antireflet 4 présente avantageusement une épaisseur comprise entre 30 nm et 100 nm.

Comme illustré à la figure 3, la première couche antireflet 4 est déposée directement et localement sur la couche de polysilicium 3 formée lors de l'étape b), de manière à définir des zones libres ZL en surface de la couche de polysilicium 3, c'est-à-dire des zones non recouvertes par la première couche antireflet 4.

### Oxydation thermique

L'étape d) est avantageusement exécutée à une température strictement inférieure à 850°C, de préférence comprise entre 700°C et 800°C. L'étape d) est avantageusement exécutée en utilisant de la vapeur d'eau. On parle alors d'oxydation thermique par voie humide.

L'étape d) est avantageusement exécutée de manière à ne pas consommer entièrement le polysilicium, au niveau des zones libres ZL de la couche de polysilicium 3. En d'autres termes, l'étape d) est avantageusement exécutée de sorte que la couche de polysilicium 3b sur laquelle est formée la seconde couche antireflet 5 présente une épaisseur non nulle à l'issue de l'étape d).

Cette étape d'oxydation thermique a pour effet de former la seconde couche antireflet 5 à l'issue de l'étape d), tout en amincissant, localement et de façon contrôlée, l'épaisseur de la couche de polysilicium 3b sous-jacente.

### Seconde couche antireflet

La seconde couche antireflet 5 formée à l'issue de l'étape d) est un oxyde thermique de polysilicium présentant avantageusement une épaisseur comprise entre 40 nm et 100 nm. En d'autres termes, la seconde couche antireflet 5 formée à l'issue de l'étape d) est un oxyde de polysilicium obtenu par oxydation thermique, de préférence humide, de la couche de polysilicium 3b sous-jacente.

### Cellule photovoltaïque

Afin d'obtenir une cellule photovoltaïque, le procédé selon l'invention comporte préférentiellement des étapes, non illustrées, consistant à :
- former une zone semi-conductrice à la première surface 10 du substrat 1 ;
- former une couche de passivation sur la zone semi-conductrice ;
- mettre en contact la zone semi-conductrice avec une électrode ;
- mettre en contact la partie 3a de la couche de polysilicium avec une électrode.

Un objet de l'invention est une cellule photovoltaïque, comportant :
- un substrat 1 en silicium cristallin, comprenant :
   une première surface 10 ;
   une seconde surface 11, opposée à la première surface 10, et recouverte d'au moins un film d'oxyde tunnel 2 ;
- une couche de polysilicium 3, formée sur le film d'oxyde tunnel 2, et comprenant :
   une première partie 3a présentant une première épaisseur de préférence comprise entre 60 nm et 90 nm ;
   une seconde partie 3b, adjacente à la première partie 3a, et présentant une seconde épaisseur strictement inférieure à la première épaisseur, la seconde épaisseur étant de préférence strictement inférieure à 10 nm ;
- une première couche antireflet 4, formée sur la première partie 3a de la couche de polysilicium 3, et réalisée dans un premier matériau adapté pour assurer une barrière à l'oxydation thermique du polysilicium ;
- une seconde couche antireflet 5, formée sur la seconde partie 3b de la couche de polysilicium 3, et réalisée dans un second matériau différent du premier matériau, le second matériau étant un oxyde thermique de polysilicium.

Une telle cellule photovoltaïque est obtenue à l'issue de l'étape d). La première surface 10 du substrat 1 peut être la face avant ou la face arrière de la cellule photovoltaïque.

## Revendications

1. Procédé de fabrication d'une cellule photovoltaïque, comportant les étapes :
a) prévoir un substrat (1) en silicium cristallin, comprenant :
- une première surface (10) ;
- une seconde surface (11), opposée à la première surface (10), et recouverte d'au moins un film d'oxyde tunnel (2) ;
b) former une couche de polysilicium (3) sur le film d'oxyde tunnel (2) ;
c) former une première couche antireflet (4) sur une partie (3a) de la couche de polysilicium (3) de sorte que la couche de polysilicium (3) présente des zones libres (ZL), la première couche antireflet (4) étant adaptée pour assurer une barrière à l'oxydation thermique de ladite partie (3a) de la couche de polysilicium (3) ;
d) oxyder thermiquement les zones libres (ZL) de la couche de polysilicium (3) de manière à former une seconde couche antireflet (5) sur lesdites zones libres (ZL).

2. Procédé selon la revendication 1, dans lequel l'étape d) est exécutée à une température strictement inférieure à 850°C, de préférence comprise entre 700°C et 800°C.

3. Procédé selon la revendication 1 ou 2, dans lequel la seconde couche antireflet (5) formée à l'issue de l'étape d) est un oxyde thermique de polysilicium présentant une épaisseur comprise entre 40 nm et 100 nm.

4. Procédé selon l'une des revendications 1 à 3, dans lequel l'étape d) est exécutée en utilisant de la vapeur d'eau.

5. Procédé selon l'une des revendications 1 à 4, dans lequel la couche de polysilicium (3) formée lors de l'étape b) présente une épaisseur initiale, et dans lequel la couche de polysilicium (3b) sur laquelle est formée la seconde couche antireflet (5) présente une épaisseur strictement inférieure à l'épaisseur initiale à l'issue de l'étape d).

6. Procédé selon la revendication 5, dans lequel la couche de polysilicium (3b) sur laquelle est formée la seconde couche antireflet (5) présente une épaisseur strictement inférieure à 10 nm.

7. Procédé selon la revendication 5 ou 6, dans lequel l'épaisseur initiale de la couche de polysilicium (3) formée lors de l'étape b) est comprise entre 60 nm et 90 nm.

8. Procédé selon l'une des revendications 5 à 7, dans lequel la partie (3a) de la couche de polysilicium (3) sur laquelle est formée la première couche antireflet (4) conserve l'épaisseur initiale à l'issue de l'étape d).

9. Procédé selon l'une des revendications 1 à 8, dans lequel la couche de polysilicium (3) formée lors de l'étape b) est dopée de type p ou de type n avec une concentration de dopants préférentiellement comprise entre 5.10¹⁷ at.cm⁻³ et 5.10²⁰ at.cm⁻³.

10. Procédé selon l'une des revendications 1 à 9, dans lequel la première couche antireflet (4) formée lors de l'étape c) est réalisée dans au moins un matériau sélectionné dans le groupe comportant l'alumine, un nitrure de silicium, un oxyde de titane.

11. Procédé selon l'une des revendications 1 à 10, dans lequel le film d'oxyde tunnel (2), recouvrant la seconde surface (11) du substrat (1) prévu lors de l'étape a), présente une épaisseur strictement inférieure à 3 nm.

12. Procédé selon l'une des revendications 1 à 11, dans lequel le substrat (1) prévu lors de l'étape a) et la couche de polysilicium (3) formée lors de l'étape b) sont dopés du même type de conductivité, le substrat (1) présentant préférentiellement une épaisseur strictement inférieure à 250 µm, plus préférentiellement inférieure à 200 µm.

13. Cellule photovoltaïque, comportant :
- un substrat (1) en silicium cristallin, comprenant :
une première surface (10) ;
une seconde surface (11), opposée à la première surface (10), et recouverte d'au moins un film d'oxyde tunnel (2) ;
- une couche de polysilicium (3), formée sur le film d'oxyde tunnel (2), et comprenant :
une première partie (3a) présentant une première épaisseur de préférence comprise entre 60 nm et 90 nm ;
une seconde partie (3b), adjacente à la première partie (3a), et présentant une seconde épaisseur strictement inférieure à la première épaisseur, la seconde épaisseur étant de préférence strictement inférieure à 10 nm ;
- une première couche antireflet (4), formée sur la première partie (3a) de la couche de polysilicium (3), et réalisée dans un premier matériau adapté pour assurer une barrière à l'oxydation thermique du polysilicium ;
- une seconde couche antireflet (5), formée sur la seconde partie (3b) de la couche de polysilicium (3), et réalisée dans un second matériau différent du premier matériau, le second matériau étant un oxyde thermique de polysilicium.

## Patentansprüche

1. Verfahren zur Herstellung einer Photovoltaikzelle, das folgende Schritte umfasst:
a) Bereitstellen eines Substrats (1) aus kristallinem Silicium, umfassend:
- eine erste Oberfläche (10);
- eine der ersten Oberfläche (10) gegenüberliegende zweite Oberfläche (11), die mit mindestens einem Tunneloxidfilm (2) bedeckt ist;
b) Bilden einer Polysiliciumschicht (3) auf dem Tunneloxidfilm (2);
c) Bilden einer ersten Antireflexionsschicht (4) auf einem Teil (3a) der Polysiliciumschicht (3) derart, dass die Polysiliciumschicht (3) freie Zonen (ZL) aufweist, wobei die erste Antireflexionsschicht (4) zur Gewährleistung einer Barriere gegen die thermische Oxidation des Teils (3a) der Polysiliciumschicht (3) ausgelegt ist;
d) thermisches Oxidieren der freien Zonen (ZL) der Polysiliciumschicht (3) zur Bildung einer zweiten Antireflexionsschicht (5) auf den freien Zonen (ZL).

2. Verfahren nach Anspruch 1, wobei Schritt d) bei einer Temperatur streng unter 850 °C, vorzugsweise zwischen 700 °C und 800 °C, durchgeführt wird.

3. Verfahren nach Anspruch 1 oder 2, wobei es sich bei der am Ende von Schritt d) gebildeten zweiten Antireflexionsschicht (5) um ein thermisches Polysiliciumoxid mit einer Dicke zwischen 40 nm und 100 nm handelt.

4. Verfahren nach einem der Ansprüche 1 bis 3, wobei Schritt d) unter Verwendung von Wasserdampf durchgeführt wird.

5. Verfahren nach einem der Ansprüche 1 bis 4, wobei die in Schritt b) gebildete Polysiliciumschicht (3) eine Anfangsdicke aufweist und wobei die Polysiliciumschicht (3b), auf der die zweite Antireflexionsschicht (5) gebildet wird, am Ende von Schritt d) eine Dicke aufweist, die streng kleiner als die Anfangsdicke ist.

6. Verfahren nach Anspruch 5, wobei die Polysiliciumschicht (3b), auf der die zweite Antireflexionsschicht (5) gebildet wird, eine Dicke von streng weniger als 10 nm aufweist.

7. Verfahren nach Anspruch 5 oder 6, wobei die Anfangsdicke der in Schritt b) gebildeten Polysiliciumschicht (3) zwischen 60 nm und 90 nm liegt.

8. Verfahren nach einem der Ansprüche 5 bis 7, wobei der Teil (3a) der Polysiliciumschicht (3), auf dem die erste Antireflexionsschicht (4) gebildet wird, am Ende von Schritt d) die Anfangsdicke behält.

9. Verfahren nach einem der Ansprüche 1 bis 8, wobei die in Schritt b) gebildete Polysiliciumschicht (3) vom p-Typ oder n-Typ ist, wobei die Dotandkonzentration bevorzugt zwischen 5×10¹⁷ at.cm⁻³ und 5×10²⁰ at.cm⁻³ liegt.

10. Verfahren nach einem der Ansprüche 1 bis 9, wobei die in Schritt c) gebildete Antireflexionsschicht (4) aus mindestens einem Material aus der Gruppe bestehend aus Aluminiumoxid, einem Siliciumnitrid und einem Titanoxid hergestellt wird.

11. Verfahren nach einem der Ansprüche 1 bis 10, wobei der Tunneloxidfilm (2), der die zweite Oberfläche (11) des in Schritt a) bereitgestellten Substrats (1) bedeckt, eine Dicke von streng weniger als 3 nm aufweist.

12. Verfahren nach einem der Ansprüche 1 bis 11, wobei das in Schritt a) bereitgestellte Substrat (1) und die in Schritt b) gebildete Polysiliciumschicht (3) mit dem gleichen Typ von Leitfähigkeit dotiert sind, wobei das Substrat (1) bevorzugt eine Dicke von streng weniger als 250 µm, weiter bevorzugt weniger als 200 µm, aufweist.

13. Photovoltaikzelle, umfassend:
- ein Substrat (1) aus kristallinem Silicium, umfassend:
eine erste Oberfläche (10);
eine der ersten Oberfläche (10) gegenüberliegende zweite Oberfläche (11), die mit mindestens einem Tunneloxidfilm (2) bedeckt ist;
- eine auf dem Tunneloxidfilm (2) gebildete Polysiliciumschicht (3), umfassend:
einen ersten Teil (3a) mit einer ersten Dicke, die vorzugsweise zwischen 60 nm und 90 nm liegt;
einen zweiten Teil (3b), der dem ersten Teil (3a) benachbart ist und eine zweite Dicke aufweist, die streng kleiner als die erste Dicke ist, wobei die zweite Dicke vorzugsweise streng kleiner als 10 nm ist;
- eine auf dem ersten Teil (3a) der Polysiliciumschicht (3) gebildete und aus einem Material, das zur Gewährleistung einer Barriere gegen die thermische Oxidation des Polysiliciums ausgelegt ist, hergestellte erste Antireflexionsschicht (4);
- eine auf dem zweiten Teil (3b) der Polysiliciumschicht (3) gebildete und aus einem von dem ersten Material verschiedenen zweiten Material hergestellte zweite Antireflexionsschicht (5), wobei sich bei dem zweiten Material um ein thermisches Polysiliciumoxid handelt.

## Claims

1. Process for manufacturing a photovoltaic cell, comprising the steps:
a) providing a crystalline silicon substrate (1), comprising:
- a first surface (10);
- a second surface (11), opposite the first surface (10), and covered with at least one tunnel oxide film (2);
b) forming a polysilicon layer (3) on the tunnel oxide film (2);
c) forming a first antireflection layer (4) on a portion (3a) of the polysilicon layer (3) so that the polysilicon layer (3) has free zones (ZL), the first antireflection layer (4) being suitable for providing a barrier to the thermal oxidation of said portion (3a) of the polysilicon layer (3);
d) thermally oxidizing the free zones (ZL) of the polysilicon layer (3) so as to form a second antireflection layer (5) on said free zones (ZL).

2. Process according to Claim 1, in which step d) is carried out at a temperature strictly below 850°C, preferably between 700°C and 800°C.

3. Process according to Claim 1 or 2, in which the second antireflection layer (5) formed at the end of step d) is a thermal polysilicon oxide having a thickness of between 40 nm and 100 nm.

4. Process according to one of Claims 1 to 3, in which step d) is carried out using water vapour.

5. Process according to one of Claims 1 to 4, in which the polysilicon layer (3) formed during step b) has an initial thickness, and in which the polysilicon layer (3b) on which the second antireflection layer (5) is formed has a thickness strictly less than the initial thickness at the end of step d).

6. Process according to Claim 5, in which the polysilicon layer (3b) on which the second antireflection layer (5) is formed has a thickness strictly less than 10 nm.

7. Process according to Claim 5 or 6, in which the initial thickness of the polysilicon layer (3) formed during step b) is between 60 nm and 90 nm.

8. Process according to one of Claims 5 to 7, in which the portion (3a) of the polysilicon layer (3) on which the first antireflection layer (4) is formed retains the initial thickness at the end of step d).

9. Process according to one of Claims 1 to 8, in which the polysilicon layer (3) formed during step b) is p-type or n-type doped with a dopant concentration preferentially between 5×10¹⁷ at.cm⁻³ and 5×10²⁰ at.cm⁻³.

10. Process according to one of Claims 1 to 9, in which the first antireflection layer (4) formed during step c) is produced from at least one material selected from the group comprising alumina, a silicon nitride, a titanium oxide.

11. Process according to one of Claims 1 to 10, in which the tunnel oxide film (2), covering the second surface (11) of the substrate (1) provided during step a), has a thickness strictly less than 3 nm.

12. Process according to one of Claims 1 to 11, in which the substrate (1) provided during step a) and the polysilicon layer (3) formed during step b) are doped with the same type of conductivity, the substrate (1) preferentially having a thickness strictly less than 250 µm, more preferentially less than 200 µm.

13. Photovoltaic cell, comprising:
- a crystalline silicon substrate (1), comprising:
a first surface (10);
a second surface (11), opposite the first surface (10), and covered with at least one tunnel oxide film (2);
- a polysilicon layer (3), formed on the tunnel oxide film (2), and comprising:
a first portion (3a) having a first thickness preferably between 60 nm and 90 nm;
a second portion (3b), adjacent to the first portion (3a), and having a second thickness strictly less than the first thickness, the second thickness preferably being strictly less than 10 nm;
- a first antireflection layer (4), formed on the first portion (3a) of the polysilicon layer (3), and produced from a first material suitable for providing a barrier to the thermal oxidation of the polysilicon;
- a second antireflection layer (5), formed on the second portion (3b) of the polysilicon layer (3), and produced from a second material different from the first material, the second material being a thermal polysilicon oxide.
